# EUROPÄISCHE PATENTSCHRIFT

(11) **EP 0 340 345 B1**
(45) Veröffentlichungstag und Bekanntmachung des Hinweises auf die Patenterteilung: **27.01.1993**
(21) Anmeldenummer: 88121571.9
(22) Anmeldetag: 23.12.1988
(51) Int. Cl.: C23C 14/56, H01L 21/00

(54) **Vorrichtung zum Ein- und Ausschleusen von Substraten aus einem Vakuumkessel**
Device for loading and unloading substrates from a vacuum chamber
Appareillage de chargement et déchargement des substrats dans une chambre à vide

(30) Priorität: 03.05.1988 DE 3814924
(43) Veröffentlichungstag der Anmeldung: 08.11.1989
(73) Patentinhaber: LEYBOLD AKTIENGESELLSCHAFT, D-63450 Hanau (DE)
(72) Erfinder: Walde, Michael, D-6458 Rodenbach (DE); Zeidler, Peter, D-6450 Hanau 7 (DE); Domröse, Dirk, D-3045 Bispingen-Behringen (DE)

(56) Entgegenhaltungen:
- EP-A- 0 238 751
- US-A- 4 550 239
- US-A- 4 676 884
- EXTENDED ABSTRACTS, FALL MEETING, Chicago, IL, 09.-14. Oktober 1988, Band 88/2, Princeton, NJ, US; L.HUSSLA et al.: "A SMIF-vacuum interface chamber for 200 mm wafer cassette loading and unloading of a multichamber etching apparatus" Seiten 599-600

## Beschreibung

Die Erfindung betrifft eine Vorrichtung für die Entnahme einer Substrate enthaltenden Kassette aus einem Gehäuse und für deren Weitertransport zu einer Vakuumkammer und zur Einschleusung in den Innenraum der Vakuumkammer zum Zwecke der Bearbeitung der Substrate, sowie zu ihrer anschließenden Ausschleusung aus der Vakuumkammer, ihrem Rücktransport und ihrem Wiedereinsatz in das Gehäuse.

Es ist allgemein bekannt, daß es beim Beschichten oder Plasmaätzen von Substraten, beispielweise von Datenspeichern, in einer Hochvakuumprozeßkammer wesentlich darauf ankommt, daß die Substrate unter Reinraum-Bedingungen gehandhabt werden. Die Substrate müssen also vollständig frei sein von Stäuben oder sonstigen in der ungereinigten Umgebungsluft stets vorhandenen Schwebeteilchen oder Partikel. Üblich ist es daher, bereits die Räume, in denen die eigentlichen Beschichtungs- oder Ätzanlagen aufgestellt sind, zu Reinräumen auszubauen, d. h. daß die durch derartige Räume strömende Luft vor dem Eintritt in diese Räume Filter passiert, wobei alle im Raum aufgestellten Anlagen und Einrichtungen besonders gereinigt sein müssen. Auch das für die Anlagen notwendige Bedienpersonal benötigt besondere Kleidung und muß im übrigen an bestimmte Verhaltensweisen gewöhnt werden. Das Handhaben der Substrate unter solchen Reinraum-Bedingungen erfordert jedoch einen erheblichen finanziellen Aufwand und bringt darüber hinaus auch eine Vielzahl von Unbequemlichkeiten mit sich. Schließlich können derartig ausgelegte Reinräume auch nur ein begrenztes Maß an Sauberhaltung garantieren.

Einen begrenzten Schritt zur Lösung der Kontaminationsund Materialfließprobleme stellt das Aufbewahren und Transportieren der Substrate in genormten Boxen oder Containern dar. Diese Boxen, die eine Kassette zur Halterung der Substrate enthalten, besitzen an ihrer Unterseite einen speziellen Verschlußmechanismus mit einem passenden Gegenstück am einzelnen Gerät. Im Inneren der Gerätekammer entsteht so ein kleiner, vom äußeren Reinraum getrennter Reinraum. Beim Be- und Entladen eines Geräts mit derartigen Boxen öffnen sich die beiden Verschlußplatten an der Box und am Gerät gleichzeitig, so daß Partikel zwischen den beiden Schmutzteilchen aufweisenden Außenseiten der Verschlußplatten eingeschlossen werden, die schließlich auf die Substrate bzw. in das Innere der Geräte oder Vorrichtungen gelangen.

Aufgabe der vorliegenden Erfindung ist es deshalb, eine Vorrichtung des eingangs genannten Typs zu schaffen, die mit einem Minimum an Aufwand den Transport einer mit Substraten gefüllten, in einer Box befindlichen Kassette aus einem lokalen Reinraum in eine Anlage, z. B. eine Vakuumbeschichtungsanlage, unter Reinraumbedingungen ermöglicht und ein anschließendes Bearbeiten und Ausschleusen der Substrate aus der Anlage in die Kassette bzw. in die Box gestattet. Die Vorrichtung soll auch sicherstellen, daß alle beim Aus- und Einschleusen der Kassette und beim Transport der Kassette von der Box in die Vakuumkammer anfallenden Stäube abgespült bzw. von der Kassette und den Substraten entfernt werden, so daß eine weitgehend staubfreie Bearbeitung der Substrate ermöglicht wird.

Erfindungsgemäß wird diese Aufgabe durch einen im Bereich einer Einschleusöffnung eines die Vorrichtung teilweise umschließenden Unterkastens vorgesehene Schleusenplatte gelöst, auf der die Kassette abstellbar ist, während die Kassette von dem an ihrer Unterseite offenen Gehäuse umschlossen ist, dessen den unteren Rand des Gehäuses umschließenden Rahmenteil auf dem oberen Wandteil des Unterkastens abgestützt ist, wobei die Schleusenplatte von einer Hubeinrichtung in vertikaler und/oder horizontaler Richtung verfahrbar ist, während das Gehäuse auf dem Unterkasten dichtend aufsitzt und dabei die Einschleussöffnung für die Kassette verschließt, wonach die Schleusenplatte bis an einen Durchlaß zu dem mit dem Unterkasten verbundenen Vakuumkessel verfahrbar und von der Schleusenplatte verschließbar ist.

Vorzugsweise ist die Hubeinrichtung aus einem auf horizontal angeordneten Schienen oder Stangen gleitend gelagerten Transportschlitten gebildet, wobei der Transportschlitten mit Hubzylindern versehen ist, deren Kolbenstangen oder Hubglieder die Schleusenplatte tragen, an der ihrerseits eine Antriebseinheit befestigt ist, die auf einen Stempel einwirkt, an dessen oberem Ende eine Trägerplatte angeordnet ist, die der Halterung der Kassette dient.

Zweckmäßigerweise weist der Unterkasten der Vorrichtung eine Auslaßöffnung für einen diesen durchspülenden Luftstrom auf und ist über eine Rohrleitung an eine Motorgebläseeinheit angeschlossen.

Die Hubeinrichtung ist zumindest teilweise von einem im Inneren des Unterkastens angeordneten Käfig aus Lochoder Rippenblechen umschlossen, wobei sich der über die Rohrleitung eintretende Luftstrom zumindest beim Durchströmen des Käfigs laminar ausbildet. Alle Stäube, die beim Transport der Kassette mit der Vorrichtung im Unterkasten anfallen, werden also von der den Unterkasten quer durchspülenden Luft aufgenommen und aus der Auslaßöffnung im unteren Teil des Unterkastens hinausgetragen.

Mit Vorteil weist das sich auf dem oberen Wandteil des Unterkastens abstützende Gehäuse für die die Substrate haltende Kassette ein die auf der Unterseite der Kassette vorgesehene Öffnung umschließendes Rahmenteil auf, dessen lichte Weite etwa derjenigen der Einschleusöffnung entspricht. Dieses mit einer ring- oder rahmenförmigen Dichtung versehene Rahmenteil liegt daher so fest auf dem oberen Wandteil auf, daß keinerlei Schmutzteile, Abrieb oder dergleichen in den Unterkasten über die im oberen Wandteil vorgesehene Öffnung eindringen kann.

In einer bevorzugten Ausführungsform ist der Durchlaß für den Vakuumkessel am oberen Wandteil des Unterkastens der Vorrichtung angeordnet, wobei die lichte Weite des Durchlasses kleiner bemessen ist als die entsprechende Breite der Schleusenplatte, jedoch größer als die korrespondierende Abmessung der Trägerplatte zur Aufnahme des Kassettenbodens.

Zweckmäßigerweise ist der Vakuumkessel über eine Transportkammer mit der Hochvakuumprozeßkammer verbunden, wobei die Anschlußöffnungen zwischen der Transportkammer einerseits und dem Vakuumkessel bzw. der Prozeßkammer andererseits über Schieber oder Ventilkörper verschließbar sind und wobei in der Transportkammer ein Transportarm mit einem an diesem angeordneten Substrathalter schwenkbar gelagert ist, der einerseits sowohl bis in den Bereich der Kassette als auch andererseits bis in den Bereich einer Substratauflage oder von Trägerbolzen, die sich in der Prozeßkammer befinden, bewegbar ist.

Um eine genaue Plazierung jedes Substrats im Vakuumkessel zu gestatten, ermöglicht die mit der Schleusenplatte verbundene Motorgetriebeeinheit ein schrittweises Ausfahren des Stempels in Abhängigkeit der Bewegung des Transportarms über eine an sich bekannte elektrische Schritt-Schalteinrichtung, wobei die Höhe des Vakuumkessels so bemessen ist, daß das in der Kassette zuunterst gehaltene Substrat noch bis in den Schwenkbereich des Substrathalters des Transportarms bewegbar ist.

Die Erfindung läßt die verschiedensten Ausführungsmöglichkeiten zu; eine davon ist in den anhängenden Zeichnungen schematisch näher dargestellt, und zwar zeigen:
- Fig. 1: den Schnitt quer durch den Unterkasten der Vorrichtung mit einem auf den Unterkasten aufgesetzten Gehäuse für eine Kassette, wobei sich die Kassette selbst in der Vakuumkammer der Vorrichtung befindet und mit einem auf dem oberen Wandteil des Unterkastens angeordneten Vakuumkessel,
- Fig. 2 - 4: die Vorrichtung gemäß Figur 1, wobei die Kassette jeweils in den verschiedenen Phasen ihres Transportweges dargestellt ist und
- Fig. 5: die mit der Vakuumkammer gemäß den Figuren 1 bis 4 verbundene Prozeßkammer und die die Prozeßkammer mit der Vakuumkammer verbindende Transportvorrichtung.

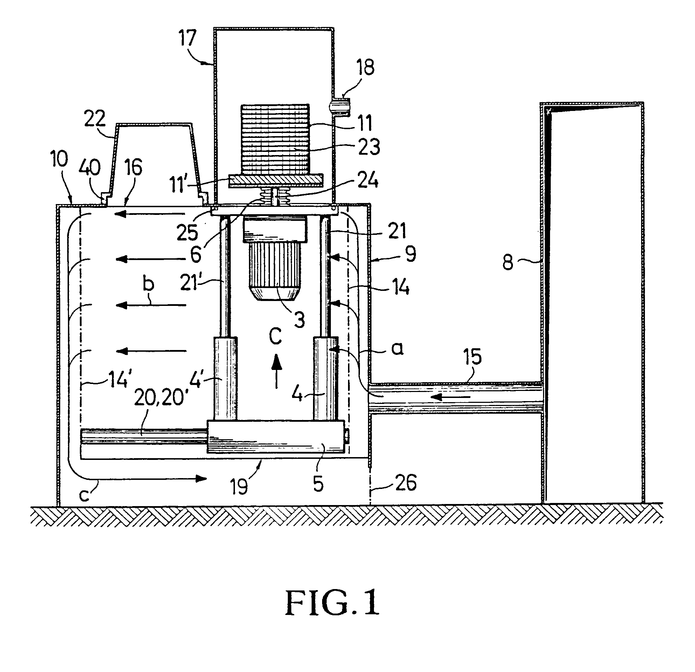

Die Vorrichtung gemäß Figur 1 besteht im wesentlichen aus einem kastenförmigen Unterkasten 9 mit einem oberen Wandteil 10 mit einer Einschleusöffnung 16, einem auf den Unterkasten 9 aufgesetzten Vakuumkessel 17, einer neben dem Unterkasten 9 angeordneten Motorgebläseeinheit 8, einer die Motorgebläseeinheit 8 mit dem Unterkasten 9 verbindenden Rohrleitung 15, einer den Vakuumkessel 17 mit einem nicht näher dargestellten Pumpensatz verbindenden Saugleitung 18, einem im Innenraum des Unterkastens 9 angeordneten Käfig 19, dessen Seitenwände aus Loch- oder Rippenblechen 14, 14' gebildet sind, einem auf parallelen Kolbenstangen 20, 20' gehalten und geführten Transportschlitten 5, mit einer auf diesem abgestützten Schleusenplatte 13 mit Hubzylindern 4, 4' und Hubstangen 21, 21' und einer mit der Schleusenplatte 13 verbundenen Antriebseinheit 3.

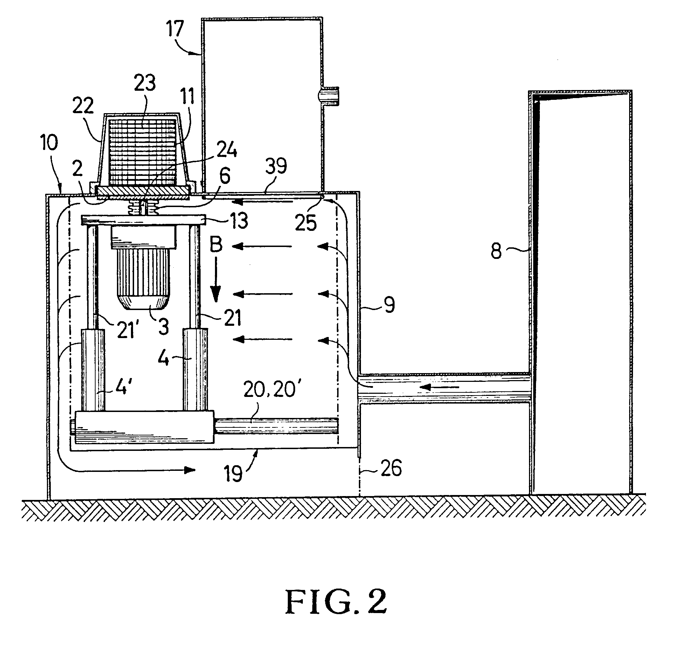

Wie Figur 2 zeigt, ist auf das obere Wandteil 10 des Unterkastens 9 im Bereich der Einschleusöffnung 16 das auf ihrer Unterseite offene Gehäuse 22 einer Kassette 11 aufgesetzt, die eine Vielzahl von Substraten 23, 23' aufweist. Die Einschleusöffnung 16 ist durch eine Trägerplatte 2, auf der die Kassette 11 ruht, von unten her verschlossen, wobei die Trägerplatte 2 ihrerseits auf einem von einem Balgen 6 umschlossenen Stempel 24 ruht, der über die Antriebseinheit 3 in vertikaler Richtung bewegbar ist.

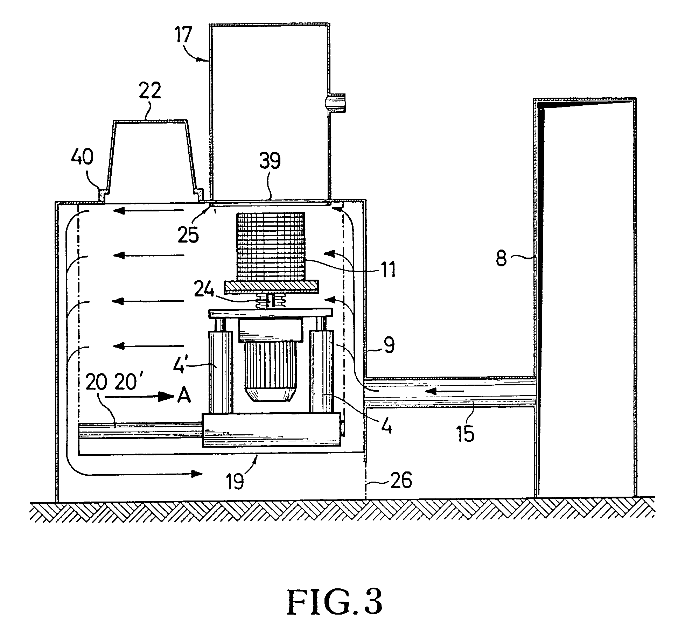

Wie aus Figur 3 ersichtlich ist, kann die Kassette 23 durch Absenken der Schleusenplatte 13 mit Hilfe der in die Hubzylinder 4, 4' einfahrbaren Hubstangen 21, 21' in eine untere Position bewegt werden, in der die Einschleusöffnung 16 vom Gehäuse 22 abgedeckt ist. Auf zwei parallelen, horizontal angeordneten Kolbenstangen 20, 20' ist die Schleusenplatte 13 anschließend in Pfeilrichtung A nach rechts verfahrbar, so daß die Kassette 11 genau unterhalb des Vakuumkessels 17 positionierbar ist. Mit Hilfe der beiden Hubzylinder 4, 4' läßt sich die Schleusenplatte 13 anschließend, wie dies in Figur 1 angedeutet ist, in Pfeilrichtung C vertikal nach oben zu bewegen, bis die Oberseite der Schleusenplatte 13 an dem rahmenförmigen Dichtring 25 auf der Unterseite des oberen Wandteils 10 anliegt.

Schließlich kann der Stempel 24 von der Antriebseinheit 3, die aus einem Motor- und einem Getriebeteil besteht, in Pfeilrichtung D vertikal nach oben zu bewegt werden, wobei die auf der Trägerplatte 2 abgestellte Kassette 11, 11' bis in den oberen Abschnitt des Vakuumkessel 17 verfahrbar ist.

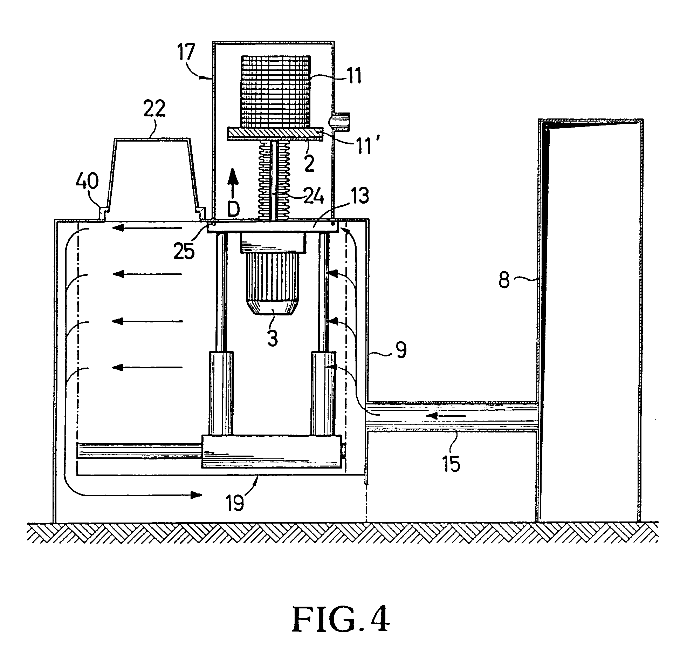

Wie aus den Figuren 1 bis 4 ersichtlich, ist der Unterkasten 9 in Richtung der Pfeile a, b bzw. c von Luft durchströmt, wobei diese Luft von der Gebläseeinheit 8 aus über die Rohrleitung 15 in den Unterkasten 9 gefördert wird. Im Unterkasten 9 verteilt sich der Luftstrom a gleichmäßig über dessen ganze Höhe und strömt dann quer durch das Rippenblech 14 in Pfeilrichtung b, passiert anschließend das Rippenblech 14 auf der gegenüberliegenden Seite des Unterkastens 9, strömt dann senkrecht an der Innenwand des Unterkastens 9 hinunter und tritt dann in Pfeilrichtung c aus der Auslaßöffnung 26 in den freien Luftraum aus. Die Gebläseeinheit 8 ist dabei so ausgelegt, daß sie nicht nur Luft mit bestimmten Druck und Geschwindigkeit in die Rohrleitung 15 fördert, sondern sie ist auch in der Lage, die aus der Umgebung angesaugte Luft in hohen Maße zu reinigen bzw. von Stäuben zu befreien. Da alle bewegten Teile der Vorrichtung im Unterkasten 9 angeordnet sind, ist die den Unterkasten 9 laminar durchströmende Luft auch in der Lage, allen möglicherweise entstehenden Abrieb von den Substraten und den Teilen im Inneren der Vorrichtung abzuwaschen und fortzuspülen, so daß im Unterkasten 9 vollkommene Reinraumbedingungen gegeben sind.

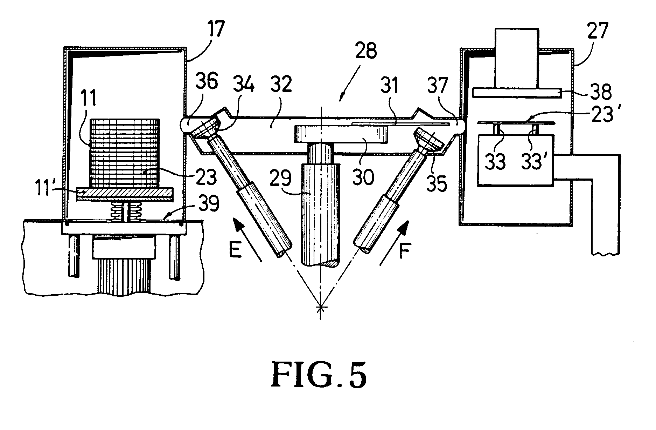

Wie aus Figur 5 ersichtlich, ist neben der in den Figuren 1 bis 4 dargestellten Vorrichtung noch eine Hochvakuumprozeßkammer 27 angeordnet, die über eine Be- und Entladevorrichtung 28 mit dem Vakuumkessel 17 in Verbindung steht. Die in der Kassette 11, 11' gestapelten Substrate 23, 23'... werden von einem von der Welle 29 bewegten Transportarm 30 mit Substrathalter 31 aus der Kassette 11, 11'... entnommen und dann durch eine Schwenkbewegung aus dem Vakuumkessel 17 durch die Transportkammer 32 bis in die Hochvakuumprozeßkammer 27 bewegt und dort auf den Trägerbolzen 33, 33'... abgelegt. Um ein Erfassen und Loslassen der Substrate 23, 23',... vom Substrathalter 31 zu ermöglichen, sind einerseits die Kassette 11 und andererseits die Trägerbolzen 33, 33' geringfügig vertikal bewegbar. Damit ein ungewollter Druckausgleich zwischen der Hochvakuumprozeßkammer 27 und dem Vakuumkessel 17 über die Transportkammer 32 vermieden werden kann, sind Ventilkörper 34, 35 vorgesehen, die jeweils die Anschlußöffnungen 36, 37 zwischen der Transportkammer 32 und dem Vakuumkessel 17 bzw. der Prozeßkammer 27 verschließen können, indem sie in Pfeilrichtung E bzw. F bewegt werden. In der Prozeßkammer 27 ist eine Beschichtungsquelle 38 angeordnet, mit deren Hilfe das Substrat 23' bearbeitbar ist.

### Bezugszeichenliste

- 2: Trägerplatte
- 3: Antriebseinheit, Motorgetriebeeinheit
- 4, 4': Hubzylinder
- 5: Transportschlitten
- 6: Balgen
- 7: Dichtung
- 8: Gebläseeinheit
- 9: Unterkasten
- 10: oberes Wandteil
- 11, 11': Kassette
- 12: Reinraumboden
- 13: Schleusenplatte
- 14, 14': Rippenblech
- 15: Rohrleitung
- 16: Einschleusöffnung
- 17: Vakuumkessel, Vakuumkammer
- 18: Saugleitung
- 19: Käfig
- 20, 20': Kolbenstange
- 21, 21': Hubstange, Hubglied
- 22: Gehäuse
- 23, 23',: Substrat
- 24: Stempel
- 25: rahmenförmiger Dichtring
- 26: Auslaßöffnung
- 27: Hochvakuumprozeßkammer
- 28: Be- und Entladevorrichtung
- 29: Welle
- 30: Transportarm
- 31: Substrathalter
- 32: Transportkammer
- 33, 33',: Trägerbolzen
- 34: Ventilkörper
- 35: Ventilkörper
- 36: Anschlußöffnung
- 37: Anschlußöffnung
- 38: Beschichtungsquelle
- 39: Durchlaß
- 40: Rahmenteil

## Patentansprüche

1. Vorrichtung für die Entnahme einer Substrate (23, 23', ...) enthaltenden Kassette (11, 11') aus einem Gehäuse (22) und für deren Weitertransport zu einer Vakuumkammer (17) und zur Einschleusung in den Innenraum der Vakuumkammer (17) zum Zwecke der Bearbeitung der Substrate (23, 23', ...) sowie zu ihrer anschließenden Ausschleusung aus der Vakuumkammer (17), ihrem Rücktransport und ihrem Wiedereinsatz in das Gehäuse (22), **gekennzeichnet durch** eine im Bereich einer Einschleusöffnung (16) eines die Vorrichtung teilweise einhüllenden Unterkastens (9) vorgesehene Schleusenplatte (13), auf der die Kassette (11, 11') abstellbar ist, während die Kassette (11, 11') von dem an ihrer Unterseite offenen Gehäuse (22) umschlossen ist, dessen den unteren Rand des Gehäuses (22) umschließenden Rahmenteil (40) auf dem oberen Wandteil (10) des die Vorrichtung teilweise umhüllenden Unterkastens (9) abgestützt ist, wobei die Schleusenplatte (13) von einer Hubeinrichtung (21, 21'; 4, 4'; 5; 20, 20') in vertikaler und/oder in horizontaler Richtung verfahrbar ist, während das Gehäuse (22) auf dem Unterkasten (9) dichtend aufsitzt und dabei die Einschleusöffnung (16) für die Kassette (11, 11') verschließt, wonach die Schleusenplatte (13) bis an einen Durchlaß (39) zu dem mit dem Unterkasten (9) verbundenen Vakuumkessel (17) verfahrbar und von der Schleusenplatte (13) verschließbar ist.

2. Vorrichtung nach Anspruch 1, **dadurch gekennzeichnet,** daß die Hubeinrichtung aus einem auf horizontal angeordneten Schienen oder Kolbenstangen (20, 20') gleitend gelagerten Transportschlitten (5) gebildet ist, wobei der Transportschlitten (5) mit Hubzylindern (4, 4') versehen ist, deren Hubstangen oder Hubglieder (21, 21') die Schleusenplatte (13) tragen, an der ihrerseits eine Antriebseinheit (3) befestigt ist, die auf einen Stempel (24) einwirkt, an dessen oberen Ende eine Trägerplatte (2) angeordnet ist, die der Halterung der Kassette (11, 11') dient.

3. Vorrichtung nach den Ansprüchen 1 und 2, **dadurch gekennzeichnet,** daß der Unterkasten (9) der Vorrichtung eine Auslaßöffnung (26) für einen diesen durchspülenden Luftstrom (a, b, c) aufweist und über eine Rohrleitung (15) an eine Gebläseeinheit (8) anschließbar ist.

4. Vorrichtung nach Anspruch 3**, dadurch** **gekennzeichnet,** daß die Hubeinrichtung (21, 21'; 4, 4'; 5; 20, 20') zumindest teilweise von einem im Inneren des Unterkastens (9) angeordneten Käfig (19) aus Loch- oder Rippenblechen (14, 14') umschlossen ist, wobei sich der über die Rohrleitung (15) eintretende Luftstrom (a, b, c) zumindest beim Durchströmen des Käfigs (19) laminar ausbildet.

5. Vorrichtung nach einem oder mehreren der vorhergehenden Patentansprüche, **dadurch gekennzeichnet,** daß das sich auf dem oberen Wandteil (10) des Unterkastens (9) abstützende Gehäuse (22) für die die Substrate (23, 23') haltende Kassette (11, 11') ein die auf der Unterseite der Kassette (11, 11') vorgesehene Öffnung umschließendes Rahmenteil (40) aufweist, dessen lichte Weite etwa derjenigen der Einschleusöffnung (16) entspricht.

6. Vorrichtung nach einem oder mehreren der vorhergehenden Ansprüche, **dadurch gekennzeichnet,** daß der Durchlaß (39) für den Vakuumkessel (17) am oberen Wandteil (10) des Unterkastens (9) der Vorrichtung angeordnet ist, wobei die lichte Weite des Durchlasses (39) kleiner bemessen ist als die entsprechende Breite der Schleusenplatte (13), jedoch größer als die korrespondierende Abmessung der Trägerplatte (2) zur Aufnahme des Bodens (11') der Kassette (11).

7. Vorrichtung nach einem oder mehreren der vorhergehenden Ansprüche, **dadurch gekennzeichnet,** daß der Vakuumkessel (17) über eine Transportkammer (32) mit einer Hochvakuumprozeßkammer (27) verbunden ist, wobei die Anschlußöffnungen (36, 37) zwischen der Transportkammer (32) einerseits und dem Vakuumkessel (17) bzw. der Hochvakuumprozeßkammer (27) andererseits über Schieber oder Ventilkörper (34, 35) verschließbar sind und wobei in der Transportkammer (32) ein Transportarm (30) mit einem an diesem angeordneten Substrathalter (31) schwenkbar gelagert ist, der einerseits sowohl bis in den Bereich der Kassette (11) als auch andererseits bis in den Bereich einer Substratablage oder von Trägerbolzen (33, 33'), die sich in der Prozeßkammer (27) befinden, bewegbar ist.

8. Vorrichtung nach einem oder mehreren der vorhergehenden Ansprüche, **dadurch gekennzeichnet,** daß die mit der Schleusenplatte (13) verbundene Motorgetriebeeinheit (3) ein schrittweises Ausfahren des Stempels (24) in Abhängigkeit der Bewegung des Transportarms (30) über eine an sich bekannte elektrische Schritt-Schalteinrichtung ermöglicht, wobei die Höhe des Vakuumkessels (17) so bemessen ist, daß das in der Kassette (11, 11') zuunterst gehaltene Substrat (23) noch bis in den Schwenkbereich des Substrathalters (31) des Transportarms (30) bewegbar ist.

## Claims

1. A device for removing a cartridge (11, 11') containing substrates (23, 23',...) from a housing (22) and for the further transport thereof to a vacuum chamber (17) and for loading into the interior of the vacuum chamber (17) for the processing of the substrates (23, 23'....) and for their subsequent unloading from the vacuum chamber (17), their return transport and their re-insertion into the housing (22), characterised by a transfer plate (13) which is arranged in the region of a loading opening (16) of a bottom box (9) which partially encloses the device and on which the cartridge (11, 11') can be deposited, while the cartridge (11, 11') is surrounded by the housing (22) which is open on its underside and whose frame member (40), which surrounds the lower edge of the housing (22), is supported on the upper wall member (10) of the bottom box (9) which partially encloses the device, where the transfer plate (13) can be moved in the vertical and/or horizontal directions by a lifting device (21, 21'; 4, 4'; 5; 20, 20'), while the housing (22) is positioned in sealing fashion on the bottom box (9) and thereby closes the loading opening (16) for the cartridge (11, 11'), whereupon the transfer plate (13) can be moved to an opening (39) leading to the vacuum tank (17) connected to the bottom box (9) and can be closed by the transfer plate (13).

2. A device as claimed in Claim 1, characterised in that the lifting device is formed by a transport slide (5) mounted in sliding fashion on horizontally disposed rails or piston rods (20, 20'), where the transport slide (5) is provided with lifting cylinders (4, 4'), the lifting rods or lifting elements (21, 21') of which support the transfer plate (13) to which a drive unit (3) is attached, which drive unit (3) acts on a ram (24) at the upper end of which is arranged a carrier plate (2) which serves to support the cartridge (11, 11').

3. A device as claimed in Claims 1 and 2, characterised in that the bottom box (9) of the device contains an outlet opening (26) for an air flow (a, b, c), by which it is flushed through, and can be connected via a pipeline (15) to a fan unit (8).

4. A device as claimed in Claim 3, characterised in that the lifting device (21, 21'; 4, 4'; 5; 20, 20') is at least partially enclosed by a cage (19) which consists of perforated or ribbed plates (14, 14') and is arranged inside the bottom box (9), where the air flow (a, b, c) which enters the pipeline (15) forms a laminar flow at least when passing through the cage (19).

5. A device as claimed in one or more of the preceding claims, characterized in that the housing (22), which is supported on the upper wall member (10) of the bottom box (9), for the cartridge (11, 11') which holds the substrates (23, 23') comprises a frame member (40) which surrounds the opening formed in the underside of the cartridge (11, 11') and the internal width of which corresponds approximately to that of the loading opening (16).

6. A device as claimed in one or more of the preceding claims, characterised in that the opening (39) for the vacuum tank (17) is formed in the upper wall member (10) of the bottom box (9) of the device, where the internal width of the opening (39) is contrived to be smaller than the corresponding width of the transfer plate (13), but larger than the corresponding dimension of the carrier plate (2) which supports the base (11') of the cartridge (11).

7. A device as claimed in one or more of the preceding claims, characterised in that the vacuum tank (17) is connected via a transport chamber (32) to a high vacuum process chamber (27), where the connecting openings (36, 37) between the transport chamber (32) on the one hand and the vacuum tank (17) and high vacuum process chamber (27) on the other hand can be closed via slides or valve elements (34, 35) and where a transport arm (30) with a substrate holder (31) arranged thereon is pivotably mounted in the transport chamber (32), where said substrate holder (31) can be moved on the one hand into the region of the cartridge (11) and on the other hand into the region of a substrate support or carrier rods (33, 33') which are arranged in the process chamber (27).

8. A device as claimed in one or more of the preceding claims, characterised in that the motor driven gear unit (3) which is connected to the transfer plate (13) permits a stepped extension of the ram (24) as a function of the movement of the transport arm (30) via an electric step-by-step switching device known *per se,* where the height of the vacuum tank (17) is contrived to be such that the lowermost substrate (23) contained in the cartridge (11, 11') can still be moved into the pivoting range of the substrate holder (31) of the transport arm (30).

## Revendications

1. Appareillage pour extraire d'un boîtier (22) une cassette (11, 11') contenant des substrats (23, 23', ...) et pour en poursuivre le transport dans une chambre sous vide (17) et pour l'introduire, avec éclusage, dans l'espace intérieur de la chambre sous vide (17) dans le but de traiter les substrats (23, 23', ...), ainsi que pour l'extraire ensuite hors de la chambre sous vide (17), la transporter en retour et la réintroduire dans le boîtier (22), assemblage caractérisé par une plaque d'écluse (13) qui est prévue dans la zone d'une ouverture d'éclusage (16) d'un caisson inférieur (9) enclosant partiellement l'appareillage et sur laquelle la cassette (11, 11') peut se déposer, pendant que la cassette (11, 11') est entourée par son boîtier (22) qui est ouvert à sa face inférieure et dont la partie formant cadre (40), qui entoure le bord inférieur du boîtier (22), s'appuie sur la partie formant paroi supérieure (10) du caisson inférieur (9) enclosant partiellement l'appareillage, appareillage dans lequel la plaque d'écluse (13) peut être déplacée, en direction verticale et/ou horizontale, par un mécanisme de déplacement (21, 21'; 4, 4'; 5; 20, 20'), pendant que le boîtier (22) repose, de façon étanche, sur le caisson inférieur (9) et y obture l'ouverture d'éclusage (16) pour la cassette (11, 11'), après quoi la plaque d'écluse (13) peut être amenée à un passage (39) vers la chambre sous vide (17) reliée au caisson inférieur (9) et ce passage peut être obturé par la plaque d'écluse (13).

2. Appareillage selon la revendication 1, caractérisé par le fait que le mécanisme de déplacement est formé par un chariot de transport (5) qui porte, en glissant, sur des rails ou des tiges de piston (20, 20') disposés horizontalement, le chariot de transport (5) étant muni de vérins (4, 4') dont les tiges ou les éléments de déplacement (21, 21') portent la plaque d'écluse (13), à laquelle, de son côté, est fixé un organe d'entrainement (3) qui agit sur une chandelle (24) à l'extrémité supérieure de laquelle est disposée une plaque support (2) qui sert à tenir la cassette (11, 11').

3. Dispositif selon les revendications 1 et 2, caractérisé par le fait que le caisson inférieur (9) de l'appareillage présente une ouverture d'évacuation (26) pour un flux d'air (a, b, c) qui traverse ce caisson inférieur en le rinçant et par le fait que ce caisson inférieur peut être relié à un organe de soufflage (8) par l'intermédiaire d'une conduite tubulaire (15).

4. Dispositif selon la revendication 3, caractérisé par le fait que le mécanisme de déplacement (21, 21'; 4, 4'; 5; 20, 20') est entouré, au moins partiellement par une cage (19), en tôles perforées ou en tôles persiennes (14, 14'), disposée à l'intérieur du caisson inférieur (9), le flux d'air (a, b, c) qui entre par la conduite tubulaire (15) formant un écoulement laminaire au moins lors de la traversée de la cage.

5. Appareillage selon l'une ou plusieurs des revendications précédentes, caractérisé par le fait que le boîtier (22), qui s'appuie sur la partie formant paroi supérieure (10) du caisson inférieur (9), pour la cassette (11, 11') contenant le substrat (23, 23'), présente une partie formant cadre (40) qui entoure l'ouverture prévue sur la face inférieure de la cassette (11, 11') et dont le passage libre correspond à peu près à celui de l'ouverture d'écluse (16).

6. Appareillage selon l'une ou plusieurs des revendications précédentes, caractérisé par le fait que le passage (39) conduisant à la chambre sous vide (17) est disposé à la partie formant paroi supérieure (10) du caisson inférieur (9) de l'appareillage, la dimension libre du passage (69) étant inférieure à la largeur correspondante de la plaque d'écluse (13), mais supérieure à la dimension correspondante de la plaque support (2) de réception du fond (11') de la cassette (11).

7. Appareillage selon l'une ou plusieurs des revendications précédentes, caractérisé par le fait que la chambre sous vide (17) est reliée, par l'intermédiaire d'une chambre de transport (32), avec une chambre (27) de processus sous vide élevé, les ouvertures de raccordement (36, 37) entre la chambre de transport (32) d'une part et la chambre sous vide (17) ou la chambre (27) de processus sous vide élevé d'autre part pouvant être obturées au moyen de vannes ou d'obturateurs de soupape (34, 35) et étant précisé que dans la chambre de transport (32) porte, avec liberté de pivotement, un bras de transport (30) qui présente un porte-substrat (31) disposé sur ce bras et qui peut se déplacer aussi bien d'une part jusque dans la zone de la cassette (11) que d'autre part jusque dans la zone de dépose du substrat ou dans la zone de tétons supports (33, 33') qui se trouvent dans la chambre de processus (27).

8. Appareillage selon l'une ou plusieurs des revendications précédentes, caractérisé par le fait que l'organe formant motoréducteur (3) relié à la plaque d'écluse (13) permet une extension, pas à pas, de la chandelle (24) en fonction du mouvement du bras de transport (30), par l'intermédiaire d'un dispositif électrique de commutation pas à pas connu en soi, la hauteur de la chambre sous vide (17) étant dimensionnée de façon que le substrat (23) contenu le plus bas dans la cassette (11, 11') puisse encore être amené dans la zone de pivotement du porte-substrat (31) du bras de transport (30).
